(19) Europäisches Patentamt
European Patent Office
Office européen des brevets

(11) **EP 4 324 652 A1**

(12) **EUROPEAN PATENT APPLICATION**
published in accordance with Art. 153(4) EPC

(43) Date of publication:
**21.02.2024  Bulletin 2024/08**

(21) Application number: **22788052.3**

(22) Date of filing: **30.03.2022**

(51) International Patent Classification (IPC):
**B41C 1/00** *(2006.01)*       **D04H 13/00** *(2006.01)*
**G03F 7/00** *(2006.01)*        **G03F 7/095** *(2006.01)*
**G03F 7/36** *(2006.01)*

(52) Cooperative Patent Classification (CPC):
**B41C 1/00; D04H 13/00; G03F 7/00; G03F 7/095;
G03F 7/36**

(86) International application number:
**PCT/JP2022/016060**

(87) International publication number:
**WO 2022/220127 (20.10.2022 Gazette 2022/42)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **15.04.2021  JP 2021068920
15.04.2021  JP 2021068918**

(71) Applicant: **Asahi Kasei Kabushiki Kaisha
Tokyo 1000006 (JP)**

(72) Inventors:
• **AKIYAMA, Hiroki**
  **Tokyo 100-0006 (JP)**
• **KUSAKABE, Junichi**
  **Tokyo 100-0006 (JP)**
• **KOMATSU, Takashi**
  **Tokyo 100-0006 (JP)**
• **TAKAHASHI, Yasuhito**
  **Tokyo 100-0006 (JP)**
• **MATSUMOTO, Kouji**
  **Tokyo 100-0006 (JP)**

(74) Representative: **Strehl Schübel-Hopf & Partner
Maximilianstrasse 54
80538 München (DE)**

(54) **DEVELOPING MEDIUM, HEAT DEVELOPING METHOD, AND HEAT DEVELOPING SYSTEM**

(57)    A development medium for flexographic heat development, the development medium having a porosity of 35% or more and 95% or less, and an elastic recovery rate of 40% or more and 99% or less.

EP 4 324 652 A1

**Description**

Technical Field

The present invention relates to a development medium, a heat development method, and a heat development system.

Background Art

In recent years, flexographic printing has been widely used as a method for printing soft packages such as paper or films. A plate material for letterpress printing typified by flexographic printing includes, for example, a photosensitive resin plate having a photosensitive resin composition layer on a support.
A method for producing a flexographic printing plate from such a photosensitive resin plate includes, for example, the following method.
First, the whole surface of a photosensitive resin composition layer is subjected to ultraviolet exposure (called back exposure) through a support to establish a uniform photocured layer. Next, relief exposure is performed from the back side, i.e., the uncured surface side of the photosensitive resin composition layer which is the side opposite to the ultraviolet exposed surface to obtain an original flexographic printing plate. Next, relief exposure is performed. Examples of a method for the relief exposure include a method of performing ultraviolet exposure via a transparent image carrier, such as a negative film, which permits selective transmission of an ultraviolet ray, and a method of performing ultraviolet exposure via a thin layer with an ultraviolet transmitting portion formed by infrared laser ablation based on an image as digital information. The photosensitive resin composition of the non-exposed portion of the original flexographic printing plate is removed by washing with a developing solution, for example, so that a relief image is formed to obtain a flexographic printing plate.
Meanwhile, a developing step of a solvent-free process which does not use an organic solvent in a developing solution has been studied with growing environmental consciousness in recent years.
Among others, a heat development scheme, which performs development by heating an original flexographic printing plate after relief exposure to melt a non-exposed portion, and removing the unmelted non-exposed portion with a nonwoven fabric or the like, permits solventless development and has received attention.
As for techniques regarding the heat development scheme, for example, Patent Literature 1 has proposed a method for performing a development treatment in a dry process. This method has the advantages that: neither organic solvent wastes nor contaminated wastewater byproducts are generated in a washing removal step; and drying for a long time is not required after the development treatment. Also, Patent Literature 2 has proposed a nonwoven fabric made of polyester which can more effectively remove a photosensitive resin composition of a non-exposed portion.
On the other hand, problems of the heat development scheme compared with conventional solvent development methods are coarse surface roughness of a finally obtained flexographic printing plate and easy occurrence of adverse effects such as ink adhesion due to surface residues of a nonwoven fabric or the like used in development.
In light of these problems, Patent Literature 3 has proposed a technique of controlling the surface roughness of a plate at the time of heat development.

Citation List

Patent Literature

       Patent Literature 1: Japanese Patent No. 3117749
       Patent Literature 2: Japanese Patent Laid-Open No. 2009-109606
       Patent Literature 3: Japanese Patent No. 5827746

Summary of Invention

Technical Problem

However, the techniques disclosed in Patent Literatures 1 and 2 still have insufficient removability of a photosensitive resin composition of a non-exposed portion and require a nonwoven fabric or the like having about dozen times the area of an original printing plate for heat development. Therefore, their problems are that the techniques are susceptible to further improvement from the viewpoint of waste reduction.

Although the technique proposed in Patent Literature 3 controls the surface roughness of a flexographic printing plate, its problem is that the technique is still susceptible to improvement in the above-described ink adhesion.

In view of the above-described problems of the conventional techniques, an object of the present invention is to provide a development medium for flexographic heat development for obtaining a flexographic printing plate excellent in removability of a photosensitive resin composition of a non-exposed portion in the case of using a heat development scheme.

Another object of the present invention is to provide a system for heat development improved in ink adhesion in the case of using a heat development scheme.

Solution to Problem

The present inventors have conducted diligent studies in order to solve the problems and have found that the above-described problems can be solved by using a development medium having a specific porosity and elastic recovery rate in a heat development process, and thereby completed the present invention.

That is, the present invention is as follows.

[1] A development medium for flexographic heat development, the development medium having

a porosity of 35% or more and 95% or less, and
an elastic recovery rate of 40% or more and 99% or less.

[2] The development medium according to [1], wherein the elastic recovery rate is 65% or more and 99% or less.

[3] The development medium according to [1] or [2], wherein

a grade of Gakushin abrasion fuzz is grade 4.0 or higher and grade 5.0 or lower.

[4] The development medium according to any one of [1] to [3], wherein
an opening size is 1.0 $\mu$m or larger and 50.0 $\mu$m or smaller.

[5] The development medium according to any one of [1] to [4], wherein
a fiber length is 50 mm or larger.

[6] The development medium according to any one of [1] to [5], wherein
the development medium comprises a polyester-based resin and/or a polyester-based copolymer.

[7] The development medium according to any one of [1] to [6], wherein
the development medium comprises a fiber layer having a fiber diameter of 0.1 $\mu$m or larger and 5.0 $\mu$m or smaller.

[8] The development medium according to any one of [1] to [7], wherein

the development medium comprises at least two fiber layers having a fiber diameter of 5.0 $\mu$m or larger and 30.0 $\mu$m or smaller, and
the fiber layer having a fiber diameter of 0.1 $\mu$m or larger and 5.0 $\mu$m or smaller is included as an intermediate layer between the fiber layers having a fiber diameter of 5.0 $\mu$m or larger and 30.0 $\mu$m or smaller.

[9] The development medium according to any one of [1] to [8], wherein
a weight basis is 10 g/m$^2$ or more and 60 g/m$^2$ or less.

[10] The development medium according to any one of [1] to [9], wherein
a thickness is 15 $\mu$m or larger and 300 $\mu$m or smaller.

[11] A heat development method using a heat development system of an original flexographic printing plate,

the heat development system of an original flexographic printing plate having: a melting unit that melts a non-exposed portion of a photosensitive resin composition; and an absorption removal unit having an absorbent layer, wherein
the absorbent layer is the development medium according to any one of [1] to [10], and
the heat development method comprises absorbing and removing the non-exposed portion by contacting the absorbent layer with the non-exposed portion.

[12] A heat development system of an original flexographic printing plate, comprising:

a melting unit that melts a non-exposed portion of a photosensitive resin composition; and
an absorption removal unit that absorbs and removes the non-exposed portion by contacting an absorbent layer with the non-exposed portion, wherein
the absorbent layer is the development medium according to any one of [1] to [10].

[13] The heat development system according to [12], wherein

in the photosensitive resin composition,
an amount of a component having a weight average molecular weight (Mw) of 70000 or more by GPC measurement is 60% or more.

[14] The heat development system according to [12] or [13], wherein

in the photosensitive resin composition,
the amount of the component having the weight average molecular weight (Mw) of 70000 or more by GPC measurement is 60% or more and 80% or less.

Advantageous Effects of Invention

The present invention can provide a development medium for flexographic heat development excellent in removability of a photosensitive resin composition of a non-exposed portion, and a heat development system and a heat development method which can produce a flexographic printing plate having reduced ink adhesion.

Description of Embodiments

Hereinafter, an embodiment for carrying out the present invention (hereinafter, referred to as "present embodiment") will be described in detail. However, the present embodiment given below is an illustration for describing the present invention and does not intend to limit the present invention to the contents given below.
The present invention can be carried out through appropriate changes or modifications without departing from the spirit of the present invention.

[Development Medium for Flexographic Heat Development]

The development medium for flexographic heat development according to the present embodiment has a porosity of 35% or more and 95% or less, and an elastic recovery rate of 40% or more and 99% or less.
The development medium for flexographic heat development according to the present embodiment is used for the removal of a non-exposed portion of a photosensitive resin composition in an original flexographic printing plate after pattern exposure in a production process of a flexographic printing plate.
Specifically, a non-exposed portion of a photosensitive resin composition in an original flexographic printing plate is heated and melted after pattern exposure. Next, the non-exposed portion is absorbed and removed using the development medium according to the present embodiment.
The development medium according to the present embodiment produces an effect of being excellent in removability of a photosensitive resin composition of a non-exposed portion.
Examples of the development medium for flexographic heat development include a woven fabric, a knitted fabric, a net-like material, or a nonwoven fabric made of organic polymer fibers, and a porous membrane or a film produced by phase separation and drawing of a resin. A nonwoven fabric is preferable from the viewpoint of achieving both developability and durability.
In the present specification, the "nonwoven fabric" refers to a web prepared by bonding or entangling fibers through thermal, mechanical, or chemical action on the fibers.

(Porosity)

The porosity of the development medium according to the present embodiment is 35% or more and 95% or less. The porosity is preferably 40% or more and 90% or less, and more preferably 45% or more and 85% or less. When the porosity is 35% or more, the amount of a photosensitive resin composition wiped off is large. When the porosity is 95% or less, practically acceptable strength is obtained for handling the development medium.
The porosity of the development medium can be measured by a method described in Examples described later.
The porosity of the development medium can be controlled to the above numeric range by adjusting heat adhesion conditions for fibers constituting the development medium. In short, the whole porosity can be controlled by adjusting the thickness of the development medium through a temperature, a pressure, or a line rate.

(Elastic Recovery Rate)

The development medium according to the present embodiment has an elastic recovery rate of 40% or more and 99% or less.

The compression characteristics of the development medium correlate with the contact area between the development medium and a photosensitive resin composition of a non-exposed portion upon pressing and largely contribute to wiping performance. Among the compression characteristics, the elastic recovery rate is a factor connected directly to the absorption performance of the development medium. At the time of development, a pressure is applied to between the development medium and an original flexographic printing plate so that the development medium is deformed. Thereafter, the development medium recovers an internal porosity when liberated from the development pressure, and thereby generates the action of absorbing a soft photosensitive resin composition of a non-exposed portion, exerting wiping performance. In short, a high elastic recovery rate of the development medium leads to improvement in the function of supporting the photosensitive resin composition because of a large amount of pores recovered at the time of unloading. In this context, when the elastic recovery rate of the development medium is 40% or more, a sufficient amount of pores recovered is obtained.

When the elastic recovery rate is 99% or less, the photosensitive resin composition layer can be sufficiently absorbed.

The elastic recovery rate of the development medium is preferably 46% or more, more preferably 65% or more, and further preferably 70% or more. The elastic recovery rate is preferably 98% or less, more preferably 97% or less, and further preferably 95% or less. The upper and lower limit values of these numeric ranges can be optionally combined.

The elastic recovery rate of the development medium according to the present embodiment can be measured by a method described in Examples described later.

The elastic recovery rate of the development medium can be controlled to the above numeric range by controlling a cloth temperature when fibers constituting the development medium enter a press roll in a heat adhesion step. Examples of a method for adjusting the cloth temperature include, but are not particularly limited to, a method of effectively exploiting the heat loss of a heating press roll using a heat retaining plate, and a method of preheating the development medium with a preheating roll.

The grade of Gakushin abrasion fuzz of the development medium according to the present embodiment is preferably grade 4.0 or higher, more preferably grade 4.2 or higher, and further preferably grade 4.5 or higher.

When the grade of Gakushin abrasion fuzz of the development medium is grade 4.0 or higher, fiber debris is unlikely to fall off during wiping. Therefore, an unwiped portion ascribable to the fall-off of the fiber debris is unlikely to occur. The upper limit of the grade of Gakushin abrasion fuzz is grade 5.0.

The grade of Gakushin abrasion fuzz of the development medium is an index of abrasion resistance and can be measured by a method described in Examples described later.

The grade of Gakushin abrasion fuzz of the development medium can be controlled to the above numeric range by adjusting heat adhesion conditions for fibers constituting the development medium. Specific examples thereof include the adjustment of a press roll temperature, a pressure, or a line rate.

(Opening Size)

The opening size of the development medium according to the present embodiment is preferably 1.0 $\mu$m or larger and 50.0 $\mu$m or smaller, more preferably 2.0 $\mu$m or larger and 30 $\mu$m or smaller, and further preferably 3.0 $\mu$m or larger and 20.0 $\mu$m or smaller.

The opening size of the development medium influences the amount of a photosensitive resin composition that can be supported by an internal pore structure in use. When the opening size of the development medium is 1.0 $\mu$m or larger, pores can sufficiently exist between adjacent threads. When the opening size is 50.0 $\mu$m or smaller, a dense fiber network is sufficiently constructed and photosensitive resin composition retaining properties tend to be easily secured.

The opening size of the development medium can be measured by a method described in Examples described later.

The opening size of the development medium can be controlled to the above numeric range by adjusting the fiber diameter or weight basis of constituent fibers.

(Fiber Length)

The fiber length of the development medium according to the present embodiment is preferably 50 mm or larger, more preferably 100 mm or larger, and further preferably 200 mm or larger.

When the fiber length of the development medium is 50 mm or larger, fewer fibers fall off during wiping and an unwiped portion is unlikely to occur. Furthermore, an effect of elevating the tensile strength of the development medium is obtained.

The fiber length of the development medium can be measured, for example, under an optical microscope or an electron microscope.

(Material)

A thermoplastic resin can be used as a material of the development medium according to the present embodiment.

Examples of the thermoplastic resin include a polyester-based resin and/or a polyester-based copolymer, a polyamide-based resin, and a resin using a cellulose derivative.

Since a non-exposed portion of a photosensitive resin composition layer is wiped off with the development medium while warmed, it is preferable that the development medium has heat resistance. The development medium satisfies this heat resistance as long as the development medium comprises the above-described resin. It is more preferable that the development medium according to the present embodiment comprises a polyester-based resin and/or a polyester copolymer from the viewpoint of affinity for a photosensitive resin composition.

Examples of the polyester-based resin include, but are not limited to, polyethylene terephthalate, polytrimethylene terephthalate, polybutylene terephthalate, polyethylene terephthalate, and polybutylene naphthalate.

(Fiber Layer)

It is preferable that the development medium according to the present embodiment comprises an extra-thin fiber layer (I layer) having preferably a fiber diameter of 0.1 $\mu$m or larger and 5.0 $\mu$m or smaller, more preferably a fiber diameter of 0.2 $\mu$m or larger and 4.5 $\mu$m or smaller, and further preferably a fiber diameter of 0.3 $\mu$m or larger and 4.0 $\mu$m or smaller.

When the development medium according to the present embodiment comprises the extra-thin fiber layer as described above, a dense network structure can be formed, drastically improving the ability to support a photosensitive resin composition. Since this supporting ability also contributes to the suppression of bleedthrough of a wiped-off photosensitive resin composition, a flexographic printing plate can be stably produced.

When the fiber diameter of the extra-thin fiber layer is 0.1 $\mu$m or larger, a dense network structure is easily formed. When the fiber diameter is 5.0 $\mu$m or smaller, an appropriate thread-thread diameter is easily retained.

The fiber diameter of the development medium can be measured by a method described in Examples described later.

The fiber diameter of the development medium can be controlled to the above numeric range, for example, by adjusting traction conditions for fibers. Specifically, a method of adjusting draw jet traction conditions is preferable when a spun-bond method is used.

(Laminate Structure of Fiber Layer)

It is preferable that the development medium according to the present embodiment comprises at least two fiber layers (II layers) having a fiber diameter of 5.0 $\mu$m or larger and 30.0 $\mu$m or smaller, and the extra-thin fiber layer (I layer) having a fiber diameter of 0.1 $\mu$m or larger and 5.0 $\mu$m or smaller is included as an intermediate layer between the fiber layers (II layers) having a fiber diameter of 5.0 $\mu$m or larger and 30.0 $\mu$m or smaller.

In the development medium having the laminate structure, the layers having a thick fiber diameter are disposed as surface layers, and wipeability is improved by a scraping effect brought about by the contact, with a resin, of the convexo-concave shape of thick fibers present on the surfaces of the development medium. A wiped-off photosensitive resin composition passes through the highly porous thick-fiber layers and can be retained in the extra-thin fiber layer. Thus, a larger number of long-term repetitive uses can be achieved.

(Weight Basis)

The weight basis of the development medium according to the present embodiment is preferably 10 g/m$^2$ or more and 60 g/m$^2$ or less, more preferably 15 g/m$^2$ or more and 65 g/m$^2$ or less, and further preferably 20 g/m$^2$ or more and 60 g/m$^2$ or less.

When the weight basis of the development medium is 10 g/m$^2$ or more, strength can be obtained to the extent that a roll-to-roll process can be carried out in the step of absorbing and removing a non-exposed portion of a photosensitive resin composition layer. When the weight basis is 60 g/m$^2$ or less, sufficient flexibility is obtained and an effect of easily wiping off a photosensitive resin composition layer by pressing is obtained.

The weight basis of the development medium can be measured by a method described in Examples described later.

The weight basis of the development medium can be controlled to the above numeric range by adjusting a discharge volume or a line rate.

(Thickness)

The thickness of the development medium according to the present embodiment is preferably 15 $\mu$m or larger and 400 $\mu$m or smaller, more preferably 20 $\mu$m or larger and 300 $\mu$m or smaller, and further preferably 30 $\mu$m or larger and 200 $\mu$m or smaller.

When the thickness of the development medium is 15 $\mu$m or larger, strength can be obtained to the extent that a roll-to-roll process can be carried out in the step of absorbing and removing a non-exposed portion of a photosensitive resin composition layer. When the thickness is 400 $\mu$m or smaller, sufficient flexibility is obtained and an effect of easily wiping off a photosensitive resin composition layer by pressing is obtained.

(Thermal Pressure Bonding)

The development medium according to the present embodiment may undergo thermal pressure bonding. In this case, the thermal pressure bonding rate (the area of a pressure-bonded portion relative to the area of the development medium) is preferably 5% or more and 20% or less, and more preferably 11% or more and 17% or less.

(Method for Producing Development Medium)

A method for producing the development medium according to the present embodiment is not limited. A production method for the fiber layers (II layers) is preferably a spun-bond method, a dry method, a wet method, or the like. The fibers for the fiber layers (II layers) can be thermoplastic resin fibers or the like. For example, a production method, such as a dry method or a wet method, using extra-thin fibers, an electrospinning method, a melt-blown method, or a force spinning method can be used as a production method for the extra-thin fiber layer (I layer) constituted by extra-thin fibers having a fiber diameter of 0.1 $\mu$m or larger and 5.0 $\mu$m or smaller. The extra-thin fiber layer (I layer) is particularly preferably formed by a melt-blown method from the viewpoint that the extra-thin fiber layer (I layer) constituted by extra-thin fibers can be formed easily and densely. Alternatively, the fibers may be used for the production of a nonwoven fabric after achievement of split yarn or fibril formation by a beating process, partial dissolution, or the like.

Examples of a method for forming the development medium having the above-described extra-thin fiber layer (I layer) and fiber layers (II layers) include a method based on integration by thermal bonding, a method of causing three-dimensional entanglement by jetting a fast water stream, and a method of causing integration using a particulate or fibrous adhesive.

Examples of the integration method by thermal bonding include integration by a thermal embossing (thermal emboss roll scheme) and integration by hightemperature hot air (air-through system).

The integration by thermal bonding is preferable from the viewpoint that a laminated development medium can be formed without the use of a binder.

The integration by thermal bonding can be performed, for example, by joining using a press roll (flat roll or emboss roll) at a temperature lower by 50 to 120°C than the melting point of a synthetic resin at a linear pressure of 100 to 1000 N/cm.

When the linear pressure in the heat adhesion step is 100 N/cm or higher, sufficient adhesion is obtained and sufficient strength is exerted. When the linear pressure is 1000 N/cm or lower, the fibers can be prevented from being largely deformed and increase in apparent density or decrease in porosity can be prevented. Thus, the advantageous effects of the present invention are effectively obtained.

This integration is capable of controlling a cloth temperature upon entry to a press roll in the heat adhesion step and thereby controlling subsequent compression characteristics of the development medium. The cloth temperature before press is a support temperature at a position of 50 cm upstream from a roll nip point. For example, in the case of a polyester material, the elastic recovery rate and compression rate of the development medium as described above can be obtained, specifically, by setting the cloth temperature before press to the range of 40 to 120°C. In this respect, the cloth temperature preset to a high temperature promotes thread crystallinity in advance, thereby suppressing excessive pressure bonding at a junction while securing a minimum necessary amount of amorphous matter for thread-thread adhesion. Thus, a support having a high elastic recovery rate can be obtained. Examples of a method for adjusting the cloth temperature to the above range include, but are not particularly limited to, a method of effectively exploiting the heat loss of a heating press roll using a heat retaining plate, and a method of preheating a nonwoven fabric with a preheating roll.

When the development medium is, for example, a nonwoven fabric, the most preferable method for producing the development medium according to the present embodiment is a method of sequentially producing a spun-bond nonwoven fabric layer and a melt-blown nonwoven fabric layer and/or a spun-bond nonwoven fabric layer, and laminating these layers, followed by pressure bonding using an emboss roll or a heat press roll.

This method is preferable for the purpose of obtaining a uniform nonwoven fabric with a low weight basis because a laminated nonwoven fabric can be formed from the same material and because production can be performed in a continuous and integrated production line.

Specifically, one or more spun-bond nonwoven fabric layers are spun on a conveyor using a thermoplastic resin and sprayed with one or more nonwoven fabric layers of extra-thin fibers having a fiber diameter of 0.1 to 5 $\mu$m by a melt-blown method using a thermoplastic resin. Then, one or more layers of a nonwoven fabric constituted by thermoplastic resin fibers using a thermoplastic resin are laminated thereto. Next, these layers are pressure-bonded and integrated by calendering using a metal roll. This method is a preferable method. The calendering includes a method of pressure-bonding nonwoven fabric layers using a heat roll. This method can be carried out in a continuous and integrated production line and is therefore suitable for the purpose of obtaining a uniform nonwoven fabric with a low weight basis.

The heat adhesion step can be performed, for example, at a temperature lower by 50°C to 120°C than the melting point of a thermoplastic resin as a reference at a linear pressure of 100 to 1000 N/cm. The linear pressure that falls within the above range in calendering is preferable from the viewpoint of improvement in the strength or porosity of a nonwoven fabric. The heat roll for use in calendering may be a roll having surface asperities such as an embossed or matte finish pattern, or may be a smooth flat roll. The surface pattern of the roll having surface asperities is an embossed pattern, a matte finish pattern, a rectangular pattern, a linear patter, or the like and is not limited as long as fibers can be thermally bonded.

[Heat Development System]

The heat development system according to the present embodiment has: a melting unit that melts a non-exposed portion of a photosensitive resin composition in an original flexographic printing plate; and an absorption removal unit that absorbs and removes the non-exposed portion by contacting an absorbent layer with the non-exposed portion. The absorbent layer is the above-described development medium according to the present embodiment.

In the heat development system according to the present embodiment, the non-exposed portion of a photosensitive resin composition in an original flexographic printing plate after pattern exposure is removed.

The melting unit heats and melts the non-exposed portion of a photosensitive resin composition. Next, the absorption removal unit absorbs and removes the non-exposed portion.

The heat development system according to the present embodiment, by having the configuration described above, produces a flexographic printing plate having reduced ink adhesion.

(Original Flexographic Printing Plate for Use in Heat Development System)

The heat development system according to the present embodiment is used for an original flexographic printing plate having a photosensitive resin composition layer subjected to pattern exposure, and melts and absorbs and removes a non-exposed portion of the photosensitive resin composition layer, as described above.

The original flexographic printing plate is configured to have at least a support (a) and a photosensitive resin composition layer (b) laminated on the support (a), before pattern exposure of the photosensitive resin composition layer. In the present specification, such a configuration is also referred to as a "photosensitive resin structure for a flexographic printing plate".

That is, as described later, an original flexographic printing plate is prepared by subjecting the photosensitive resin structure for a flexographic printing plate to pattern exposure, and a flexographic printing plate is obtained by melting and removing a non-exposed portion from the original flexographic printing plate.

<Support (a)>

Examples of the support (a) include, but are not limited to, a polyester film, a polyamide film, a polyacrylonitrile film, and a polyvinyl chloride film.

Among these, the support (a) is preferably a polyester film.

Examples of the polyester used for the support (a) include, but are not limited to, polyethylene terephthalate, polybutylene terephthalate, and polyethylene naphthalate.

The thickness of the support (a) is not particularly limited, but is preferably 50 to 300 $\mu$m.

An adhesive layer may be provided on the support (a) in order to enhance the adhesive force between the support (a) and the photosensitive resin composition layer (b) which will be described later. Examples of the adhesive layer include, but are not limited to, the adhesive layer described in International Publication No. WO 2004/104701.

<Photosensitive Resin Composition Layer (b)>

The photosensitive resin structure for a flexographic printing plate has a photosensitive resin composition layer (b) on the support (a).

The photosensitive resin composition layer (b) may be laminated directly on the support (a), or may be indirectly laminated via the above-described adhesive layer or the like.

In the photosensitive resin composition layer (b), the amount of a component having a weight average molecular weight (Mw) of 70000 or more by gel permeation chromatography (GPC) measurement is preferably 60% or more.

The amount of the component by GPC measurement can be calculated from an area ratio in a measurement curve when the tetrahydrofuran (THF)-soluble content of the photosensitive resin composition layer (b) is measured.

The amount of the component having a weight average molecular weight (Mw) of 70000 or more is 60% or more, which means that a highly elastic polymer is present in a large amount. As a result, the photosensitive resin composition layer is excellent in surface smoothness without impairing smoothness after development because reconstruction force works on the polymer constituting the photosensitive resin composition layer even when a non-exposed portion is absorbed and removed by contact with the absorbent layer, i.e., the development medium according to the present embodiment, at the time of heat development described later. Furthermore, a flexographic printing plate, by having the configuration described above, is excellent in surface elasticity at the time of printing. Moreover, the development medium can be prevented from being attached thereto at the time of heat development, and the development medium, even if attached, can be prevented from accumulating on the surface of the flexographic printing plate in a printing step. Thus, ink adhesion can be improved.

The amount of the component having a weight average molecular weight (Mw) of 70000 or more is preferably 60% or more and 80% or less.

When the amount of the component having a weight average molecular weight (Mw) of 70000 or more is 80% or less, wipeability is excellent and surface roughness after development is also excellent. Therefore, an effect of being excellent in improvement in ink adhesion is obtained.

The amount of the component having a weight average molecular weight (Mw) of 70000 or more is more preferably 63 to 78%, and further preferably 65 to 75%. In this range, improvement in ink adhesion is particularly marked.

The amount of the component having a weight average molecular weight (Mw) of 70000 or more can be controlled by adjusting the amount of a constituent material mixed which has a weight average molecular weight of 70000 or more among constituent materials for use in forming the photosensitive resin composition layer (b). The amount can be controlled, for example, by changing the content of a thermoplastic elastomer (b-1) described later.

The photosensitive resin composition layer (b) contains, for example, a thermoplastic elastomer (b-1) and preferably contains an ethylenically unsaturated compound (b-2) and a photopolymerization initiator (b-3), and may further contain a liquid diene.

The photosensitive resin composition layer (b) may further contain an auxiliary additive component, if necessary. Hereinafter, each component is described in detail.

[Thermoplastic Elastomer (b-1)]

Examples of the thermoplastic elastomer (b-1) include, but are not limited to, a copolymer having a constituent unit derived from a monovinyl-substituted aromatic hydrocarbon and a constituent unit derived from a conjugated diene. The thermoplastic elastomer (b-1) may further have a constituent unit derived from other monomers. The use of such a thermoplastic elastomer renders a flexographic printing plate excellent in elasticity and tends to be able to further reduce the attachment of the development medium at the time of heat development.

The thermoplastic elastomer (b-1) may be a random copolymer or a block copolymer, but is preferably a block copolymer having a polymer block formed from a monovinyl-substituted aromatic hydrocarbon and a polymer block formed from a conjugated diene. The use of such a thermoplastic elastomer tends to further improve a printing durability of the flexographic printing plate.

Examples of the monovinyl-substituted aromatic hydrocarbon that constitutes the thermoplastic elastomer (b-1) include, but are not limited to, styrene, t-butylstyrene, 1,1-diphenylethylene, N,N-dimethyl-p-aminoethylstyrene, N,N-diethyl-p-aminoethylstyrene, vinylpyridine, p-methylstyrene, p-methoxystyrene, tertiary-butylstyrene, $\alpha$-methylstyrene, and 1,1-diphenylethylene.

These may be used singly or in combinations of two or more thereof.

Among these, styrene is preferable from the viewpoint of enabling the photosensitive resin composition layer (b) to be molded smoothly at a relatively low temperature, and improving surface smoothness.

Examples of the conjugated diene that constitutes the thermoplastic elastomer (b-1) include, but are not limited to, butadiene, isoprene, 2,3-dimethyl-1,3-butadiene, 2-methyl-1,3-pentadiene, 1,3-hexadiene, 4,5-diethyl-1,3-octadiene, 3-butyl-1,3-octadiene, and chloroprene.

These may be used singly or in combinations of two or more thereof.

Among these, butadiene is preferable from the viewpoint of improving ink adhesion to a flexographic printing plate.

The thermoplastic elastomer (b-1) preferably has a weight average molecular weight (Mw) of 50,000 to 300,000 and more preferably 70,000 to 200,000 from the viewpoint of improvement in ink adhesion. The weight average molecular weight can be measured by gel permeation chromatography (GPC) and is expressed by a molecular weight in terms of polystyrene.

When the thermoplastic elastomer (b-1) is a block copolymer having a polymer block formed from a monovinyl-substituted aromatic hydrocarbon and a polymer block formed from a conjugated diene, examples of the thermoplastic elastomer (b-1) include elastomers including linear block copolymers represented by the following formula group (I) and/or linear block copolymers or radial block copolymers represented by the following formula group (II).

Formula group (I): $(A\text{-}B)_n$, $A\text{-}(B\text{-}A)_n$, $A\text{-}(B\text{-}A)_n\text{-}B$, $B\text{-}(A\text{-}B)_n$

Formula group (II): $[(A\text{-}B)_k]_m\text{-}X$, $[(A\text{-}B)_k\text{-}A]_m\text{-}X$, $[(B\text{-}A)_k]_m\text{-}X$, $[(B\text{-}A)_k\text{-}B]_m\text{-}X$

In the formula group (I) and the formula group (II), A represents a polymeric block consisting of a monovinyl-substituted aromatic hydrocarbon. Also, B represents a polymeric block consisting of a conjugated diene. X represents a residual group of a coupling agent such as silicon tetrachloride, tin tetrachloride, epoxidized soybean oil, a poly (halogenated hydrocarbon) compound, a carboxylic acid ester compound, a polyvinyl compound, a bisphenol type epoxy compound, an alkoxysilane compound, a halogenated silane compound, or an ester-based compound, or a residual group of a polymerization initiator such as a multifunctional organolithium compound.

In the formula group (I) and the formula group (II), n, k, and m each represent an integer of at least one, for example, 1 to 5.

The content of the conjugated diene and of the monovinyl-substituted aromatic hydrocarbon in the thermoplastic elastomer (b-1) can be measured using a nuclear magnetic resonance apparatus ($^1$H-NMR). Specifically, the contents can be measured by using JNM-LA400 (manufactured by JEOL Ltd., trade name) as a $^1$H-NMR measurement device, using deuterated chloroform as a solvent, setting the sample concentration to 50 mg/mL, setting a measurement frequency at 400 MHz, using tetramethylsilane (TMS) as a standard of chemical shifts, and setting a pulse delay to 2.904 seconds, the number of times of scanning to 64, a pulse width to 45°, and a measurement temperature to 25°C.

The copolymerization ratio (mass ratio) of the monovinyl-substituted aromatic hydrocarbon to the conjugated diene in the thermoplastic elastomer (b-1) is preferably monovinyl-substituted aromatic hydrocarbon/conjugated diene = 10/80 to 90/20, more preferably 10/90 to 85/15, and further preferably 10/90 to 60/40 from the viewpoint of the printing durability and surface smoothness of a flexographic printing plate.

When the proportion of the monovinyl-substituted aromatic hydrocarbon in the ratio (mass ratio) is 10 or more, a sufficient hardness is obtained in the photosensitive resin composition layer (b), so that appropriate printing can be performed by usual printing pressure. When the proportion of the monovinyl-substituted aromatic hydrocarbon in the copolymerization ratio (mass ratio) is 90 or less, an appropriate hardness is obtained in the photosensitive resin composition layer (b), so that inks can be sufficiently transferred to an object of printing in the printing process.

If necessary, another functional group may be introduced, a chemical modification such as hydrogenation may be performed, or another component may be copolymerized in the thermoplastic elastomer (b-1).

The content of the thermoplastic elastomer (b-1) in the photosensitive resin composition layer (b) is preferably 60% by mass or more, more preferably 60 to 80% by mass, further preferably 65 to 80% by mass, and further more preferably 65 to 75% by mass when the whole amount of the photosensitive resin composition layer (b) is assumed to be 100% by mass from the viewpoint of improvement in ink adhesion to a flexographic printing plate.

<Ethylenically Unsaturated Compound (b-2)>

The photosensitive resin composition layer (b) preferably contains an ethylenically unsaturated compound (b-2), as described above. The ethylenically unsaturated compound (b-2) is a compound having a radically polymerizable unsaturated double bond.

Examples of the ethylenically unsaturated compound (b-2) include, but are not limited to, olefins such as ethylene, propylene, vinyltoluene, styrene, and divinylbenzene; acetylenes; (meth)acrylic acid and/or derivatives thereof; haloolefins; unsaturated nitriles such as acrylonitrile; unsaturated amides such as acrylamide or methacrylamide, and derivatives thereof; unsaturated dicarboxylic acids and derivatives thereof such as maleic anhydride, maleic acid, and fumaric acid; vinyl acetates; N-vinylpyrrolidone; N-vinylcarbazole; and N-substituted maleimide compounds.

Among these, (meth)acrylic acid and/or derivatives thereof are preferable from the viewpoint of ultraviolet ray curability and printing durability of the photosensitive resin composition layer (b) after curing.

Examples of each of the derivatives include, but are not limited to, an alicyclic compound having a cycloalkyl group, a bicycloalkyl group, a cycloalkenyl group, a bicycloalkenyl group, or the like; an aromatic compound having a benzyl group, a phenyl group, a phenoxy group, a naphthalene skeleton, an anthracene skeleton, a biphenyl skeleton, a phenanthrene skeleton, a fluorene skeleton, or the like; a compound having an alkyl group, a halogenated alkyl group, an alkoxyalkyl group, a hydroxyalkyl group, an aminoalkyl group, a glycidyl group, or the like; an ester compound with a polyhydric alcohol such as an alkylene glycol, a polyoxyalkylene glycol, a polyalkylene glycol, or trimethylolpropane; and a compound having a polysiloxane structure, such as polydimethylsiloxane and polydiethylsiloxane.

In addition, the ethylenically unsaturated compound (b-2) may be a heteroaromatic compound containing an element such as nitrogen or sulfur.

Examples of the (meth)acrylic acid and/or derivatives thereof include, but are not limited to, a diacrylate and a dimethacrylate of an alkanediol such as hexanediol or nonanediol; a diacrylate and a dimethacrylate of ethylene glycol, diethylene glycol, propylene glycol, dipropylene glycol, polyethylene glycol, or butylene glycol; trimethylolpropane tri(meth)acrylate; dimethylol tricyclodecane di(meth)acrylate; isobornyl (meth)acylate; phenoxy polyethylene glycol (meth)acrylate; and pentaerythrit tetra(meth)acrylate. These may be used singly or in combinations of two or more thereof.

From the viewpoint of the mechanical strength of a flexographic printing plate, at least one (meth)acrylate is preferably used, and at least one bifunctional (meth)acrylate is more preferably used as the ethylenically unsaturated compound (b-2).

The number average molecular weight (Mn) of the ethylenically unsaturated compound (b-2) is preferably 100 or more from the viewpoint of improving nonvolatility of the ethylenically unsaturated compound (b-2) during production and storage of the photosensitive resin structure for a flexographic printing plate, preferably less than 1000 from the viewpoint of compatibility with the other components, and more preferably 200 or more and 800 or less.

The content of the ethylenically unsaturated compound (b-2) in the photosensitive resin composition layer (b) is preferably 2% by mass to 30% by mass, more preferably 2% by mass to 25% by mass, and further preferably 2% by mass to 20% by mass when the whole amount of the photosensitive resin composition layer (b) is assumed to be 100% by mass from the viewpoint of improvement in ink adhesion to a flexographic printing plate.

[Photopolymerization Initiator (b-3)]

The photosensitive resin composition layer (b) preferably contains a photopolymerization initiator (b-3).

The photopolymerization initiator (b-3) is a compound that absorbs the energy of light to produce a radical. Examples thereof include a degradable photopolymerization initiator, a hydrogen abstraction type photopolymerization initiator, and a compound having a site functioning as a hydrogen abstraction type photopolymerization initiator and a site functioning as a degradable photopolymerization initiator in the same molecule.

Examples of the photopolymerization initiator (b-3) include, but are not limited to, benzophenones such as benzophenone, 4,4-bis(diethylamino)benzophenone, 3,3',4,4'-benzophenone tetracarboxylic anhydride, and 3,3',4,4'-tetramethoxy benzophenone; anthraquinones such as t-butyl anthraquinone and 2-ethyl anthraquinone; thioxanthones such as 2,4-diethyl thioxanthone, isopropyl thioxanthone, and 2,4-dichloro thioxanthone; Michler's ketone; acetophenones such as diethoxyacetophenone, 2,2-dimethoxy-2-phenylacetophenone, 2-hydroxy-2-methyl-1-phenylpropan-1-one, benzyl dimethyl ketal, 1-hydroxycyclohexyl-phenyl ketone, 2-methyl-2-morpholino(4-thiomethylphenyl)propan-1-one, 2-methyl-1-(4-methylthiophenyl)-2-morpholino-propan-1-one, 2-benzyl-2-dimethylamino-1-(4-morpholinophenyl)-butanone, and trichloroacetophenone; benzoin ethers such as benzoin methyl ether, benzoin ethyl ether, benzoin isopropyl ether, and benzoin isobutyl ether; acylphosphine oxides such as 2,4,6-trimethylbenzoyl diphenyl phosphine oxide, bis(2,6-dimethoxybenzoyl)-2,4,4-trimethyl pentyl phosphine oxide, and bis(2,4,6-trimethylbenzoyl)-phenyl phosphine oxide; methyl benzoylformate; 1,7-bisacridinyl heptane; 9-phenyl acridine; and azo compounds such as azobisisobutyronitrile, diazonium compounds, and tetrazene compounds.

These may be used singly or in combinations of two or more thereof.

Among these, a compound having a carbonyl group is preferable, and an aromatic carbonyl compound such as benzophenones or thioxanthones is more preferable, in view of the printing durability of the flexographic printing plate.

The content of the photopolymerization initiator (b-3) in the photosensitive resin composition layer (b) is preferably 0.1 to 10% by mass, more preferably 0.1 to 5% by mass, and further preferably 0.5 to 5% by mass when the whole amount of the photosensitive resin composition layer (b) is assumed to be 100% by mass from the viewpoint of improvement in ink adhesion to a flexographic printing plate.

[Liquid Diene]

The photosensitive resin composition layer (b) preferably contains a liquid diene.

The liquid diene is a liquid compound having a carbon-carbon double bond. In the present specification, "liquid" in the "liquid diene" means a characteristic having the property of being easily flow-deformable and capable of being solidified into a deformed shape by cooling. This term corresponds to an elastomer having the following property: when an external force is applied, deformation occurs instantly depending on the external force, and when the external force is removed, the original shape is recovered in a short time.

Examples of the liquid diene include, but are not limited to, liquid polybutadiene, liquid polyisoprene, a modified product of liquid polybutadiene, a modified product of liquid polyisoprene, a liquid acrylonitrile-butadiene copolymer, and a liquid styrene-butadiene copolymer. The liquid diene is defined as a copolymer having a diene component of 50% by mass or more.

Among these, liquid polybutadiene is preferable from the viewpoint of the mechanical properties of a flexographic printing plate.

The amount of 1,2-vinyl bond in the liquid diene, preferably liquid polybutadiene, is preferably 1% or more and 80% or less, more preferably 5% or more and 70% or less, and still more preferably 5% or more and 65% or less from the viewpoint of making the hardness of the photosensitive resin structure for a flexographic printing plate, and the hardness of a flexographic printing plate using the same appropriate.

The amount of the 1,2-vinyl bond is a proportion of a conjugated diene monomer incorporated by a 1,2-bond with regard to the conjugated diene monomers incorporated by bonding forms of the 1,2-bond, a 3,4-bond, and a 1,4-bond. The amount of the 1,2-vinyl bond can be determined from the peak ratio of the proton NMR (magnetic resonance spectrum) of liquid polybutadiene.

1,2-Polybutadiene, which is the liquid polybutadiene having the 1,2-vinyl bond, is highly reactive in radical polymerization and is preferable from the viewpoint of enhancing the hardness of the photosensitive resin composition layer (b) because vinyl, which has a double bond, forms a side chain.

The liquid polybutadiene is usually a mixture of 1,2-polybutadiene having the 1,2-vinyl bond and 1,4-polybutadiene having the 1,4-vinyl bond, and it is effective that 1,4-polybutadiene is contained in the liquid diene in order to improve the softness of the photosensitive resin structure for a flexographic printing plate, and the softness of a flexographic printing plate using the same.

1,4-Polybutadiene includes cis-1,4-polybutadiene and trans-1,4-polybutadiene. Any of cis- and trans-1,4-polybutadiene has a low reactivity in radical polymerization because a vinyl group, which has a double bond, exists inside, so that a soft resin can be finally formed.

When a plurality of liquid polybutadienes each having a different amount of the 1,2-vinyl bond are mixed and used, the average value of the amounts is defined as the amount of the 1,2-vinyl bond.

From the viewpoint of capable of adjusting the reactivity of the photosensitive resin composition layer (b) easily, the whole amount of the 1,2-vinyl bond is preferably adjusted by mixing liquid polybutadiene having an amount of the 1,2-vinyl bond of 10% or less and liquid polybutadiene having an amount of the 1,2-vinyl bond of 80% or more. From the same viewpoint as above, it is more preferable that the whole amount of the 1,2-vinyl bond is adjusted by mixing liquid polybutadiene having an amount of the 1,2-vinyl bond of 5% or less and liquid polybutadiene having an amount of the 1,2-vinyl bond of 80% or more.

The number average molecular weight of the liquid diene is not particularly limited as long as it is liquid at 20°C, but is preferably 500 or more and 60000 or less, more preferably 500 or more and 50000 or less, and still more preferably 800 or more and 50000 or less from the viewpoint of the printing durability and handling properties of a flexographic printing plate obtained using the photosensitive resin structure for a flexographic printing plate.

The content of the liquid diene in the photosensitive resin composition layer (b) is preferably 10 to 30% by mass, more preferably 15 to 30% by mass, and further preferably 20 to 30% by mass when the whole amount of the photosensitive resin composition layer (b) is assumed to be 100% by mass from the viewpoint of improvement in ink adhesion to a flexographic printing plate.

[Auxiliary Additive Component]

The auxiliary additive component is not limited, and examples thereof include a polar group-containing polymer, a plasticizer other than a liquid diene, a thermal polymerization inhibitor other than a stabilizer, an antioxidant, an ultraviolet ray absorber, and a dye or pigment.

Examples of the polar group-containing polymer include, but are not limited to, a water-soluble or water-dispersible copolymer having a polar group such as a hydrophilic group, such as a carboxyl group, an amino group, a hydroxy group, a phosphate group, or a sulfate group, and a salt thereof. More specific examples thereof include an acrylonitrile-butadiene rubber containing a carboxyl group, a styrene-butadiene rubber containing a carboxyl group, a polymer of a carboxyl group-containing aliphatic conjugated diene, an emulsified polymer of an ethylenically unsaturated compound having a phosphate group or a carboxyl group, sulfate group-containing polyurethane, and carboxyl group-containing butadiene latex. These polar group-containing polymers may be used singly or in combinations of two or more thereof.

Among these, carboxyl group-containing butadiene latex is preferable from the viewpoint of obtaining a high resolution in a flexographic printing plate.

Other examples of the plasticizer other than the liquid dienes include, but are not limited to, a hydrocarbon oil such as naphthene oil and paraffin oil; a conjugated diene rubber mainly composed of a liquid diene, such as a liquid acrylonitrile-butadiene copolymer or a liquid styrene-butadiene copolymer; a polystyrene having a number average molecular weight of 2000 or less; and an ester-based plasticizer such as a sebacic acid ester or a phthalic acid ester.

These other plasticizers may have a hydroxyl group or a carboxyl group. In addition, a photopolymerizable, reactive group such as a (meth)acryloyl group may be added thereto. The other plasticizers may be used singly, or two or more thereof may be used together.

As the thermal polymerization inhibitor and the antioxidant, those usually used in the field of resin materials or rubber materials can be used. Specific examples thereof include a phenol-based material.

Examples of the phenol-based material include, but are not limited to, vitamin E, tetrakis-(methylene-3-(3',5'-di-t-butyl-4'-hydroxyphenyl)propionate)methane, 2,5-di-t-butylhydroquinone, 2,6-di-t-butyl-p-cresol, and 2-t-butyl-6-(3-t-butyl-2-hydroxy-5-methylbenzyl)-4-methylphenyl acrylate. The thermal polymerization inhibitor and the antioxidant may be used singly or in combinations of two or more thereof.

Examples of the ultraviolet ray absorber include, but are not limited to, known benzophenone-based, salicylate-based, acrylonitrile-based, metal complexbased, or hindered amine-based compounds. The dye or pigment described below may also be used as the ultraviolet ray absorber.

Examples of the ultraviolet ray absorber include, but are not limited to, 2-ethoxy-2'-ethyloxalic acid bisanilide, and 2,2'-dihydroxy-4-methoxybenzophenone.

The dye or pigment is effective as coloring means for improving visibility.

Examples of the dye include, but are not limited to, a basic dye, an acid dye, and a direct dye, which are water-soluble, and a sulfur dye, an oil-soluble dye, and a disperse dye, which are non-water-soluble. Particularly, an anthraquinone-based dye, an indigoidbased dye, and an azo-based dye are preferable, and an azo-based oil-soluble dye and the like are more preferable.

Examples of the pigment include, but are not particularly limited to, a natural pigment, a synthetic inorganic pigment, and a synthetic organic pigment. Examples of the synthetic organic pigment include an azo-based pigment, a triphenylmethane-based pigment, a quinoline-based pigment, an anthraquinone-based pigment, and a phthalocyanine-based pigment.

The total amount of the above-described auxiliary additive components to be added is preferably 0 to 10% by mass, more preferably 0 to 5% by mass, and further preferably 0 to 3% by mass when the whole amount of the photosensitive resin composition layer (b) is assumed to be 100% by mass.

[Use of Flexographic Heat Development System in Production Process of Flexographic Printing Plate, and Heat Development Method]

A method for producing a flexographic printing plate includes: the step of first performing ultraviolet ray irradiation from the support side using the above-described photosensitive resin structure for a flexographic printing plate (first step); in the case of digital plate making, the step of drawing and processing a pattern on the infrared ray ablation layer by infrared ray irradiation, or in the case of analog plate making, the step of tightly contacting a negative with the photosensitive resin composition layer (second step); the step of irradiating the photosensitive resin composition layer with an ultraviolet ray for pattern exposure using, as a mask, the infrared ray ablation layer or the negative on which the pattern is drawn and processed (third step); and the step of removing a non-exposed portion of the photosensitive resin composition layer (fourth step). In the (fourth step), the flexographic heat development system according to the present embodiment is used.

If necessary, the step of performing a post-exposure treatment is then performed to obtain a flexographic printing plate (letterpress printing plate) formed from a cured photosensitive resin composition layer.

The surface of the flexographic printing plate may be brought into contact with a liquid containing a silicone compound and/or a fluorine compound from the viewpoint of conferring peeling properties.

(First Step)

In the first step, the method of performing ultraviolet ray irradiation to the photosensitive resin composition layer (b) from a side of the support (a) is not particularly limited, and can be carried out using a known irradiation unit. The wavelength of ultraviolet ray in the irradiation is preferably 150 to 500 nm, more preferably 300 to 400 nm.

The light source of the ultraviolet ray is not limited, but, for example, a low-pressure mercury lamp, a high-pressure mercury lamp, an ultrahigh-pressure mercury lamp, a metal halide lamp, a xenon lamp, a zirconium lamp, a carbon arc lamp, or a fluorescent lamp for ultraviolet ray can be used.

This first step may be performed before or after the second step described later.

(Second Step)

In the second step, the method for drawing and processing a pattern on the infrared ray ablation layer by infrared ray irradiation is not particularly limited, and can be carried out using a known irradiation unit. The irradiation of infrared ray to the infrared ray ablation layer can be carried out from the infrared ray ablation layer side.

When the above-described photosensitive resin structure for a flexographic printing plate has a cover film, the cover film is first peeled off before the infrared ray irradiation. The infrared ray ablation layer is then pattern-irradiated with an infrared ray to decompose the resin of the irradiated part of the infrared ray, and the pattern is drawn and processed. This makes it possible to form a mask of the infrared ray ablation layer on the photosensitive resin composition layer.

In the second step, suitable examples of the infrared laser include ND/YAG laser (for example, 1064 nm) or diode laser (for example, 830 nm). Laser systems suitable for CTP plate making techniques are sold on the market, and, for example, a diode laser system CDI Spark (Esko-Graphics BV.) can be used. This laser system includes: a rotary cylindrical drum that holds the present structure; IR laser irradiation apparatus; and a layout computer, and image information is directly sent from the layout computer to the laser apparatus.

In analog plate making, a mask can be similarly formed by using a negative film.

(Third Step)

In the third step, the photosensitive resin composition layer is irradiated with an ultraviolet ray for pattern exposure using, as a mask, the infrared ray ablation layer or the negative film on which the pattern is drawn and processed. At this time, the ultraviolet ray passing through the mask promotes a curing reaction in the photosensitive resin composition layer, and a pattern formed in the infrared ray ablation layer or the negative film is transferred to the photosensitive resin composition layer in which the convex and concave are inverted. Ultraviolet ray irradiation may be performed by continuous partial irradiation or may be performed on the whole surface.

The third step can be carried out in a state where the above-described photosensitive resin structure for a flexographic printing plate is attached to a laser cylinder, but is generally performed by taking the photosensitive resin structure for a flexographic printing plate out of a laser apparatus, and irradiating with an ultraviolet ray using a conventional irradiation unit. The same irradiation unit as the one illustrated in the ultraviolet ray irradiation in the first step can be used as the irradiation unit.

(Fourth Step)

The fourth step is the step of removing a non-exposed portion of the photosensitive resin composition layer.

In the fourth step (developing step), the removal method is a heat development method.

In the melting unit of the heat development system according to the present embodiment, the photosensitive resin structure for a flexographic printing plate after the third step is heated to 40°C to 200°C to melt the photosensitive resin composition that is masked with the infrared ray ablation layer or the negative film and thereby is not irradiated with an ultraviolet ray, i.e., a non-exposed portion.

This heating of the photosensitive resin composition layer is performed by the melting unit of the heat development system according to the present embodiment.

A conventionally known melting unit can be used as long as the melting unit has a function of heating the photosensitive resin composition layer. For example, any of heating means incorporated in a roll in which the photosensitive resin structure for a flexographic printing plate is placed, and heating means placed outside the roll can be used. Examples thereof include an infrared ray lamp prepared so as to irradiate the photosensitive resin composition layer with an infrared ray.

Next, the non-exposed portion melted as described above is absorbed and removed by the absorption removal unit of the heat development system according to the present embodiment.

The absorption removal unit has an absorbent layer and eliminates the non-exposed portion by contacting the absorbent layer with the non-exposed portion and thereby absorbing and removing the non-exposed portion.

The absorbent layer is the above-described development medium according to the present embodiment, and a nonwoven fabric is preferably used as the development medium.

If necessary, a post-exposure treatment is then performed, thereby producing a flexographic printing plate.

When an intermediate layer is located between the infrared ray ablation layer and the photosensitive resin composition layer, the intermediate layer may be removed simultaneously in the developing step.

Examples

Hereinafter, the present invention will be described more specifically with reference to specific Examples and Comparative Examples, but the present invention is not limited to the following examples by any means.

Hereinafter, the length direction of a development medium is the MD direction (machine direction), and the width direction is a perpendicular direction within a development medium plane to the length direction, unless otherwise specified.

[Physical Properties and Characteristics of Development Medium for Flexographic Heat Development]

Hereinafter, the physical properties and characteristics of a development medium for flexographic heat development will be described.

((1) Weight Basis)

A nonwoven fabric was used as a development medium, and 20 cm long × 25 cm wide test pieces were collected from the nonwoven fabric at a total of nine locations per 1 m × 1 m involving three locations per m in the width direction and three locations per m in the length direction in the nonwoven fabric sample in accordance with a method stipulated in JIS L-1906.

The masses of the test pieces were measured, and the average value thereof was converted to a mass per unit area to determine a weight basis.

((2) Thickness)

A nonwoven fabric was used as a development medium, and thicknesses at 10 locations per m width were measured in a test piece (1 m in width × 0.15 m in length) of the nonwoven fabric under conditions involving a load of 9.8 kPa (load area: 1 cmφ) in accordance with a method stipulated in JIS L-1906. The average value thereof was determined.

((3) Apparent Density)

The apparent density of the nonwoven fabric was calculated according to the following expression by using the weight basis (g/m$^2$) measured as described in (1) above and the thickness (mm) measured in (2) above, and adjusting the unit.

$$\text{Apparent density} = (\text{Weight basis}) / (\text{Thickness})$$

The value of this apparent density was used in the calculation of a porosity described below.

((4) Porosity)

The porosity of the nonwoven fabric was calculated according to the following expression using the apparent density (g/cm$^3$) calculated as described in (3) above.

$$\text{Porosity} = \{1 - (\text{Apparent density}) / (\text{Density of a}$$
$$\text{resin constituting the nonwoven fabric})\} / 100$$

((5) Fiber Diameter)

The nonwoven fabric serving as a development medium was cut into 10 cm × 10 cm, and the upper and lower surfaces were pressed at a pressure of 0.30 MPa for 90 seconds using iron plates of 60°C. Then, platinum was vapor-deposited thereon.

The nonwoven fabric on which platinum was vapor-deposited was photographed using a SEM apparatus (JSM-6510 manufactured by JEOL Ltd.) under conditions involving an acceleration voltage of 15 kV and a working distance of 21 mm.

Photographing magnifications were set to 10000x for thread having a weight average fiber diameter of less than 0.5 $\mu$m, 6000$\times$ for thread having a weight average fiber diameter of 0.5 $\mu$m or larger and less than 1.5 $\mu$m, and 4000$\times$ for thread having a weight average fiber diameter of 1.5 $\mu$m or larger. The field of view of photographing at each photographing magnification was 12.7 $\mu$m $\times$ 9.3 $\mu$m for 10000$\times$, 21.1 $\mu$m $\times$ 15.9 $\mu$m for 6000$\times$, and 31.7 $\mu$m $\times$ 23.9 $\mu$m for 4000$\times$. 100 or more fibers were randomly photographed, and the fiber diameters of all the fibers were measured. However, fibers fused in the thread length direction were excluded from measurement subjects.

A weight average fiber diameter (Dw) when Ni fibers having fiber diameter Di were present was calculated according to the following expression, and the weight average fiber diameter ($\mu$m) thereby obtained was regarded as the fiber diameter of the nonwoven fabric.

$$Dw = \Sigma Wi \cdot Di = \Sigma (Ni \cdot Di^2) \ / \ (Ni \cdot Di)$$

wherein Wi = weight fraction of the fiber diameter Di = Ni·Di / $\Sigma$Ni·Di.

In Table 1, a plurality of numeric values described as the fiber diameter each represent the fiber diameter of each layer in a laminate structure.

((6) Opening Size)

The opening size of the nonwoven fabric serving as a development medium was measured using a perm porometer from Porous Materials Inc. (PMI) (model: CFP-1200AEX).

In measurement, Silwick manufactured by PMI was used as a dipping liquid, and the sample was dipped in the dipping liquid and measured after sufficient deaeration.

In this measurement apparatus, the nonwoven fabric was used as a filter. The filter was dipped as a sample for measurement in a liquid having a known surface tension in advance, and the filter was pressurized from a state in which all fine pores of the filter was covered with a liquid film. The pore diameter of the fine pores calculated from a pressure under which the liquid film was destroyed, and the surface tension of the liquid was measured.

The following numerical expression was used for calculation.

$$d = C \cdot r \ / \ P$$

wherein d (unit: $\mu$m) represents the pore diameter of the filter, r (unit: N/m) represents the surface tension of the liquid, P (unit: Pa) represents the pressure under which the liquid film having the pore diameter was destroyed, and C represents a constant.

A flow rate (wet flow rate) when the pressure P to be applied to the filter dipped in the liquid was continuously changed from a low pressure to a high pressure was measured from the above numerical expression. Under initial pressure, the flow rate is zero because even a liquid film having the largest fine pore is not destroyed. With increase in pressure, the liquid film having the largest fine pore is destroyed, and the flow rate occurs (bubble point). With further increase in pressure, the flow rate increases according to each pressure. A flow rate under a pressure where a liquid film of the smallest fine pore is destroyed agrees with a flow rate in a dry state (dry flow rate).

In a measurement method using this measurement apparatus, a value obtained by dividing a wet flow amount under a certain pressure by a dry flow rate under the same pressure thereas is called cumulative filter flow rate (unit: %). The pore diameter of a liquid film destroyed under a pressure that attains a cumulative filter flow rate of 50% is called mean-flow pore diameter, and this mean-flow pore diameter was regarded as the opening size.

Each sample was measured at three points by the above-described measurement method, and the opening size was calculated as the average value thereof.

((7) Elastic Recovery Rate)

The elastic recovery rate of the nonwoven fabric serving as a development medium was measured using MCT-50 Micro Compression Tester manufactured by Shimadzu Corp.

Testing conditions were set to a loading-unloading mode which involved applying a load up to a maximum test force to the sample, and then performing unloading up to a minimum test force for measurement.

The minimum test force was 0.05 mN, and the maximum test force was set to a test force when nonwoven fabric thickness d was deformed by 10% in a compression mode.
The elastic recovery rate was calculated as follows.

$$\text{Elastic recovery rate (\%)} = L2 / (L1 - L2) \times 100$$

L1: difference in displacement between the maximum test force and the minimum test force in the loading mode.
L2: difference in displacement between the maximum test force and the minimum test force in the unloading mode.

((8) Gakushin Abrasion Fuzz (Abrasion Resistance))

Five test pieces long in the width direction (about 30 cm in width $\times$ 3 cm in length) were collected such that the interval between the centers of the test pieces was 20 cm apart. The Gakushin abrasion fuzz of the nonwoven fabric serving as a development medium was measured using abrasion tester type II (Gakushin type) described in JIS L-0849 Test methods for color fastness to rubbing.
Each test piece was attached such that the measurement surfaces were in contact with both a testing table and a rubbing finger, and rubbed by 30 reciprocations. The appearance of the nonwoven fabric thus rubbed was examined and evaluated according to the following criteria.
Grade 5: The surface of the nonwoven fabric has no change.
Grade 4: Although the surface of the nonwoven fabric has no pilling, threads stand up one by one on the surface and slightly roughen the surface.
Grade 3: There is pilling having a length of less than 0.5 cm, or the whole surface was fuzzed.
Grade 2: There is pilling having a length of 1 cm or larger, or the rubbed surface has floc or is worn out due to abrasion.
Grade 1: The nonwoven fabric is partially broken.

((9) Removability of Photosensitive Resin Composition of Non-exposed Portion)

The following photosensitive resin composition plates were used.

(I) Solvent development-type non-exposed photosensitive resin composition plate AFP-TOP(R) (manufactured by Asahi Kasei Corporation)

An original letterpress printing plate having a polyester film as a support, having a photosensitive resin composition layer including a styrene-butadiene block copolymer as primary component, a polymerizable monomer component, a photopolymerization initiator, a plasticizer, and a thermal polymerization inhibitor, and having a thin flexible film layer. Thickness: 1.7 mm.

(II) Water development-type non-exposed photosensitive resin composition plate AWP-DEF(R) (manufactured by Asahi Kasei Corporation)

An original letterpress printing plate having a polyester film as a support, having a photosensitive resin composition layer including a styrene-butadiene block copolymer as primary component, a hydrophilic polymer, a polymerizable monomer component, a photopolymerization initiator, a plasticizer, and a thermal polymerization inhibitor, and having a thin flexible film layer. Thickness: 1.7 mm.
The plates (I) and (II) were each cut into a size of 30 cm $\times$ 30 cm, and a cover film was peeled off. Each sample was placed in Esko CDI SPARK2530, and laser drawing was performed so as to form a 10 cm $\times$ 10 cm exposed portion at the center at laser intensity of 3.8 J.
The whole surface was first exposed at 600 mJ/cm$^2$ from the support side using a lower ultraviolet lamp (UV Lamp TL80W/10R manufactured by Koninklijke Philips N.V., trade name) on "AFP-1216E" exposure machine (manufactured by Asahi Kasei Corporation, trade name) such that the relief depth of the printing plate was 0.5 mm.
Subsequently, pattern exposure was performed by irradiation with an ultraviolet ray of 8000 mJ/cm$^2$ from the cover film side using an upper lamp (UV Lamp TL80W/10R manufactured by Koninklijke Philips N.V., trade name) to obtain an original flexographic printing plate. At this time, exposure intensity was measured with a UV illuminometer MO-2 type machine manufactured by ORC MANUFACTURING CO., LTD. (manufactured by ORC MANUFACTURING CO., LTD., trade name, UV-35 filter).
The original flexographic printing plate thus exposed was fixed to a motor-driven metal roll having a diameter of 35 cm using a double-sided adhesive tape.

The nonwoven fabric for heat development serving as a development medium was placed so as to be capable of passing between a plurality of heatable metal rolls having a diameter of 5 cm.

An infrared lamp for heating the photosensitive resin composition layer was fixed onto the metal roll on which the original flexographic printing plate was held.

The infrared lamp was turned on, and the metal rolls in a state heated to 170°C were slowly (about 2 rpm) rotated by a motor. On the metal roll, the nonwoven fabric was contacted at a contact pressure of about $2.5 \times 10^5$ Pa with the photosensitive resin composition layer surface of the original flexographic printing plate, and allowed to pass therethrough.

The cycle was repetitively performed such that the relief depth, i.e., the difference in level between the exposed portion and the non-exposed portion, reached 0.5 mm.

At this time, the removability was evaluated on the basis of the number of cycles required for wiping off the non-exposed portion.

A smaller number of cycles means better removability.

It was confirmed that a sample given a score of 3 or higher in the following evaluation criteria could be expected to have a waste reduction effect.

<Evaluation Criteria>

4: The relief depth, i.e., the difference in level between the exposed portion and the non-exposed portion, reached 0.5 mm when the number of wipes was 10 or less.

3: The relief depth, i.e., the difference in level between the exposed portion and the non-exposed portion, reached 0.5 mm by 12 or less wipes, though 10 wipes were not sufficient.

2: The relief depth, i.e., the difference in level between the exposed portion and the non-exposed portion, reached 0.5 mm by 14 or less wipes, though 12 wipes were not sufficient.

1: The relief depth, i.e., the difference in level between the exposed portion and the non-exposed portion, reached 0.5 mm by 15 or more wipes.

[Production of Nonwoven Fabric for Flexographic Heat Development]

(Examples 1 (1a and 1b), 2 to 3, and 6)

The resin material described in Table 1 below was discharged at a spinning temperature of 290°C from a spinneret for spun-bond (V-shaped nozzle), and yarns were symmetrically cooled from both lateral sides (wind speed: 0.5 m/s for both) with a cooling apparatus immediately below the spinneret, followed by traction in draw jet to obtain continuous long fibers (fiber diameter: 16 μm). The fibers were opened and dispersed, and deposited on a web conveyor to form a web.

In Table 1 below, "PET/CoPET" represents fibers with a sheath-core structure of polyethylene terephthalate and a polyethylene terephthalate-based copolymer, "PET" represents polyethylene terephthalate, and "Ny" represents nylon 6.

The web was integrated with a calender roll (roll temperature: 220°C, linear pressure: 500 N/cm).

"Flat" as a calender roll type represents a calender roll for flat processing, and this calender roll applies pressure bonding over the whole surface. "Emboss" represents a calender roll for embossing, and this calender roll is a roll having asperities and applies pressure bonding on a portion of the nonwoven fabric surface.

The thermal pressure bonding rate is the ratio of the area of a pressure-bonded portion to the area of the nonwoven fabric, and its unit is %.

The position of a heat retaining plate of a heating roll was adjusted such that a cloth temperature before press, which is important for the control of the elastic recovery rate, was the temperature described in Table 1 below.

The other production conditions and the physical properties and evaluation results of the prepared nonwoven fabrics for flexographic heat development are shown in Table 1 below.

(Examples 4 and 5 (5a and 5b))

Polyethylene terephthalate (PET) was discharged at a spinning temperature of 290°C from a spinneret for the spun-bond method (V-shaped nozzle), and yarns were symmetrically cooled from both lateral sides (wind speed: 0.5 m/s for both) with a cooling apparatus immediately below the spinneret, followed by traction in draw jet to obtain continuous long fibers (fiber diameter: 16 $\mu$m). The fibers were opened and dispersed, and deposited on a web conveyor to form a web.

Subsequently, an extra-thin fiber nonwoven fabric layer (I layer) was spun by the melt-blown method using a PET solution under conditions involving a spinning temperature of 290°C, and the above-described web was sprayed therewith. In this respect, a distance from a melt-blown nozzle to the web was 300 mm. A suction power on a capture surface immediately below the melt-blown nozzle was set to 0.2 kPa, and a wind speed was set to 7 m/sec. An extra-thin fiber nonwoven fabric layer having a fiber diameter of 3 $\mu$m was thereby formed.

A web of continuous long fibers (fiber diameter: 16 $\mu$m) prepared by the same spun-bond method as above was laminated thereonto to obtain a laminated web.

The laminated web was integrated with a calender roll (roll temperature: 220°C, linear pressure: 500 N/cm).

The position of a heat retaining plate of a heating roll was adjusted such that a cloth temperature before press, which is important for the control of compression characteristics, was the temperature described in Table 1 below.

The other production conditions and the physical properties and evaluation results of the prepared nonwoven fabrics for flexographic heat development are shown in Table 1.

(Comparative Examples 1 (1a and 1b) and 2)

The resin material used was nylon (Comparative Example 1) or polyethylene terephthalate (Comparative Example 2), and the nonwoven fabric temperature before calendering was set to the atmospheric temperature of 24 to 25°C. The other conditions were the same as in Example 1 to prepare nonwoven fabrics for flexographic heat development. The physical properties and evaluation results of the prepared nonwoven fabrics for flexographic heat development are shown in Table 1 below.

In Table 1, the nonwoven fabrics for flexographic heat development were the same between (Examples 1a and 1b), (Examples 5a and 5b), or (Comparative Examples 1a and 1b).

"-" as a thermal pressure bonding rate means that thermal pressure bonding was applied over the whole surface of the nonwoven fabric because the calender roll type was flat.

[Table 1]

| | Photosensitive resin composition plate | Resin material | Fiber length | Fiber diameter | Calendering condition | | | Thickness | Weight basis | Porosity | Opening size | Elastic recovery rate | Abrasion resistance | Removability evaluation (the number of wipes) |
| | | | | | Calender roll type | Thermal pressure bonding rate (%) | Cloth temperature | Roll temperature | | | | | | | |
| | | | mm | μm | | | °C | °C | μm | g/m² | % | μm | % | Grade | |
|---|---|---|---|---|---|---|---|---|---|---|---|---|---|---|---|
| Example 1a | AFP-TOP | PET/Co-PET | >200 | 16 | Flat | - | 72 | 220 | 145 | 50 | 75% | 19.1 | 69.2 | 4.8 | 3(11) |
| Example 1b | AWP-DEF | PET/Co-PET | >200 | 16 | Flat | - | 72 | 220 | 145 | 50 | 75% | 19.1 | 69.2 | 4.8 | 3(11) |
| Example 2 | AFP-TOP | PET | >200 | 16 | Emboss | 13 | 71 | 220 | 212 | 50 | 83% | 21.8 | 93.2 | 4.2 | 4(10) |
| Example 3 | AFP-TOP | PET | >200 | 16 | Emboss | 10 | 74 | 200 | 420 | 71 | 88% | 20.4 | 96.8 | 3.7 | 3(12) |
| Example 4 | AFP-TOP | PET | >200 | 16/3/16 | Flat | - | 72 | 220 | 178 | 50 | 80% | 9.5 | 91.7 | 4.2 | 4(10) |
| Example 5a | AFP-TOP | PET | >200 | 16/3/16 | Emboss | 13 | 71 | 220 | 73 | 50 | 50% | 7.8 | 86.5 | 4.7 | 4(9) |
| Example 5b | AWP-DEF | PET | >200 | 16/3/16 | Emboss | 13 | 71 | 220 | 73 | 50 | 50% | 7.8 | 86.5 | 4.7 | 4(9) |
| Example 6 | AFP-TOP | Ny | >200 | 16 | Emboss | 13 | 73 | 200 | 204 | 50 | 82% | 23.4 | 83.1 | 4.2 | 4(10) |
| Comparative Example 1a | AFP-TOP | Ny | >200 | 16 | Emboss | 13 | 24 | 200 | 250 | 70 | 80% | 32.4 | 38.9 | 4.2 | 1(15) |
| Comparative Example 1b | AWP-DEF | Ny | >200 | 16 | Emboss | 13 | 24 | 200 | 250 | 70 | 80% | 32.4 | 38.9 | 4.2 | 1(15) |
| Comparative Example 2 | AFP-TOP | PET | >200 | 16 | Emboss | 13 | 25 | 200 | 187 | 50 | 81% | 22.5 | 31.7 | 4.1 | 2(14) |

[Production and Evaluation of Flexographic Printing Plate]

In Examples and Comparative Examples given below, flexographic printing plates were produced using a heat development system and evaluated.

Laminates 1 to 6 of a support and a photosensitive resin composition layer were produced as follows.

((1) Production of Laminate of Support and Photosensitive Resin Composition Layer)

<Production Example of Laminate 1 of Support and Photosensitive Resin Composition Layer>

70 parts by mass of TUFPRENE A (manufactured by Asahi Kasei Corporation, a styrene-butadiene-styrene block copolymer), 21 parts by mass of B-2000 (manufactured by Nippon Petrochemicals Co., Ltd., liquid polybutadiene), 7 parts by mass of 1,9-nonanediol diacrylate, 2 parts by mass of 2,2-dimethoxy-2-phenylacetophenone, and 0.3 parts by mass of 2,6-di-t-butyl-p-cresol were kneaded using a pressure kneader to prepare a photosensitive resin composition.

Next, the photosensitive resin composition was added to an extruder. Then, to one side of the photosensitive resin composition layer extruded from a T-die was laminated a support (polyethylene terephthalate film), and to the side opposite to the support-laminated side of the photosensitive resin composition layer was laminated a release film (manufactured by Mitsubishi Chemical Corporation, DIAFOIL MRV100), to thereby obtain a laminate 1 of the support and the photosensitive resin composition layer.

As a result of measuring the molecular weight distribution of the photosensitive resin composition layer by GPC, the amount of a component having a weight average molecular weight (Mw) of 70000 or more was found to be 74.3% by calculating the area of a region of the component having Mw of 70000 or more in a molecular weight distribution curve.

<Production Examples of Laminates 2 to 5 of Support and Photosensitive Resin Composition Layer>

Laminates 2 to 5 of a support and a photosensitive resin composition layer were obtained in the same manner as in the above-described laminate 1 except that the amounts (parts by mass) of TUFPRENE A and B-2000 were changed as shown in Table 2 below. Their physical properties are shown in Table 2.

<Production Example of Laminate 6 of Support and Photosensitive Resin Composition Layer>

To a pressure-resistant reaction vessel with a stirrer and a temperature-regulating jacket, 125 parts by mass of water and 2 parts by mass of an ammonium salt of $\alpha$-sulfo(1-nonylphenoxy)methyl-2-(2-propenyloxy)ethoxy-poly(oxy-1,2-ethanediyl) ("Adekaria Soap" manufactured by Asahi Denka Kogyo K.K.) as a reactive emulsifier were initially charged. The internal temperature was raised to 80°C, and an oily mixed solution of a monomer mixture consisting of 10 parts by mass of styrene, 60 parts by mass of butadiene, 23 parts by mass of butyl acrylate, 5 parts by mass of methacrylic acid, and 2 parts by mass of acrylic acid, and 2 parts by mass of t-dodecylmercaptan, and an aqueous solution consisting of 28 parts by mass of water, 1.2 parts by mass of sodium peroxodisulfate, 0.2 parts by mass of sodium hydroxide, and 2 parts by mass of ammonium salt of $\alpha$-sulfo(1-nonylphenoxy)methyl-2-(2-propenyloxy)ethoxy-poly(oxy-1,2-ethanediyl) were added at a constant flow rate for 5 hours for the oily mixed solution and for 6 hours for the aqueous solution.

Then, the temperature was kept at 80°C for 1 hour to complete the polymerization reaction, and the copolymer latex was obtained and then cooled.

Furthermore, pH of the generated copolymer latex was adjusted to 7 with sodium hydroxide, and then the unreacted monomer was removed by steam stripping method, and filtered through a wire netting of 200 mesh. Finally, the solid content concentration of the filtrate was adjusted to 40% by mass to obtain a water dispersion of the hydrophilic copolymer.

The water dispersion of the obtained hydrophilic copolymer was dried up with a vacuum dryer at 50°C to remove water to obtain a hydrophilic copolymer.

10 parts by mass of the hydrophilic copolymer, 65 parts by mass of TUFPRENE A (manufactured by Asahi Kasei Corporation, a styrene-butadiene-styrene block copolymer), 16 parts by mass of B-2000 (manufactured by Nippon Petrochemicals Co., Ltd., liquid polybutadiene), 7 parts by mass of 1,9-nonanediol diacrylate, 2 parts by mass of 2,2-dimethoxy-2-phenylacetophenone, and 0.3 parts by mass of 2,6-di-t-butyl-p-cresol were kneaded using a pressure kneader to prepare a photosensitive resin composition.

Next, the photosensitive resin composition was added to an extruder. Then, to one side of the photosensitive resin composition layer extruded from a T-die was laminated the support (polyethylene terephthalate film), and to the side opposite to the support-laminated side of the photosensitive resin composition layer was laminated a release film (manufactured by Mitsubishi Chemical Corporation, DIAFOIL MRV100), to thereby obtain a laminate 6 of the support and the photosensitive resin composition layer.

Its physical properties are shown in Table 2.

[Table 2]

|  | Amount of TUFPRENE A | Amount of B-2000 | Hydrophilic copolymer | Amount of component of Mw ≥ 70000 |
|---|---|---|---|---|
|  | [parts by mass] | [parts by mass] | [parts by mass] | [%] |
| Laminate 1 of support and photosensitive resin composition layer | 70 | 21 | 0 | 74.3 |
| Laminate 2 of support and photosensitive resin composition layer | 60 | 31 | 0 | 62.4 |
| Laminate 3 of support and photosensitive resin composition layer | 75 | 16 | 0 | 78.9 |
| Laminate 4 of support and photosensitive resin composition layer | 80 | 11 | 0 | 83.6 |
| Laminate 5 of support and photosensitive resin composition layer | 55 | 36 | 0 | 58.1 |
| Laminate 6 of support and photosensitive resin composition layer | 65 | 16 | 10 | 72.1 |

((2) Production of Infrared Ray Ablation Layer Laminate)

<Production Example of Infrared Ray Ablation Layer Laminate>

7.8 parts by mass of TUFPRENE 315 (manufactured by Asahi Kasei Corporation, styrene-butadiene block copolymer), 70.4 parts by mass of toluene, and 17.6 parts by mass of propylene glycol 1-monomethyl ether 2-acetate (PMA) were mixed to dissolve TUFPRENE 315 in the solvent. Thereafter, 4.2 parts by mass of carbon black (manufactured by Mitsubishi Chemical Corporation, #30) were further charged, then the mixture was mixed for 4 hours using a bead mill to obtain a carbon black dispersion.

A 100 μm thick PET film serving as a cover film was coated with the carbon black dispersion obtained above so that the film thickness after drying was 2.5 μm. A drying treatment at 90°C for 2 minutes was performed to obtain an infrared ray ablation layer laminate which was a laminate of the infrared ray ablation layer and the cover film.

((3) Production of Printing Plate Using Heat Development System in Examples 101 to 110 and Comparative Examples 101 to 103)

[Example 101]

The release film was peeled from the laminate of the support and the photosensitive resin composition layer, and the infrared ray ablation layer laminate was laminated in an environment with a temperature of 25°C and a humidity of 40% so that the infrared ray ablation layer was in contact with the photosensitive resin composition layer. The laminate was disposed on a hot plate set to 120°C so that the cover film side was in contact with the heating portion of the hot plate, then heat was added thereto for 1 minute to obtain photosensitive resin structure 1 for a flexographic printing plate of Example 101.

The cover film was peeled off from the photosensitive resin structure 1 for a flexographic printing plate prepared as described above. The resulting structure was placed in Esko CDI SPARK2530, and halftone images (AM 100, 133, 150, 175, and 200 lines) were drawn at laser intensity of 3.8 J.

The whole surface was first exposed at 600 mJ/cm$^2$ from the support side using a lower ultraviolet lamp (UV Lamp TL80W/10R manufactured by Koninklijke Philips N.V., trade name) on "AFP-1216E" exposure machine (manufactured by Asahi Kasei Corporation, trade name) such that the relief depth of the printing plate was 0.5 mm.

Subsequently, pattern exposure was performed by irradiation with an ultraviolet ray of 8000 mJ/cm$^2$ from the cover film side using an upper lamp (UV Lamp TL80W/10R manufactured by Koninklijke Philips N.V., trade name) to obtain an original flexographic printing plate. At this time, exposure intensity was measured with a UV illuminometer MO-2 type machine manufactured by ORC MANUFACTURING CO., LTD. (manufactured by ORC MANUFACTURING CO., LTD., trade name, UV-35 filter).

The original flexographic printing plate thus exposed was fixed to a motor-driven metal roll having a diameter of 35 cm using a double-sided adhesive tape.

The nonwoven fabric of Example 5 (which was in common between 5a and 5b) shown in Table 1 was placed as a development medium for heat development so as to be capable of passing between a plurality of heatable metal rolls having a diameter of 5 cm.

An infrared lamp for relatively rapidly heating the photosensitive resin composition layer was fixed onto the metal roll on which the original flexographic printing plate was held.

The infrared lamp was turned on, and the metal rolls in a state heated to 170°C were slowly (about 2 rpm) rotated by a motor. On the metal roll, the nonwoven fabric was contacted at a contact pressure of about $2.5 \times 10^5$ Pa with the photosensitive resin composition layer surface of the original flexographic printing plate, and allowed to pass therethrough.

The roll on which the original flexographic printing plate was held was subjected to 14 cycles to remove an uncured portion of the photosensitive resin composition layer.

[Examples 102 to 110] and [Comparative Examples 101 to 103]

The type of the laminate of the support and the photosensitive resin composition layer was changed by selection from 1 to 6 in Table 2.

Also, the type of the nonwoven fabric serving as a development medium for heat development was selected from those shown in Table 1 and changed to those shown in Table 3 below.

The nonwoven fabric was in common between Examples 1a and 1b, Examples 5a and 5b, or Comparative Examples 1a and 1b and was therefore described as Example 1, Example 5, or Comparative Example 1.

The other conditions were the same as in [Example 101] to prepare flexographic printing plates.

[Evaluation of Printing Plate]

<Evaluation of Ink Adhesion>

Flexographic printer AI-3 model (manufactured by Iyokikai Seisakusho) was used, and an OPP film was used as an object to be printed.

Process X cyan (manufactured by TOYO INK CO., LTD., trade name) was used as solvent ink. A solvent was added, and the viscosity was adjusted for 15 seconds in Zahn cup #4 manufactured by Rigo Co., Ltd. for use as ink for printing. An anilox roll with 800 lpi (cell volume: 3.8 cm$^3$/m$^2$) was used, and 3M1020 (manufactured by Sumitomo 3M Ltd., trade name) was used as a cushion tape. Printing was carried out for 100 m at a printing rate of 100 m/minute.

In this operation, in order to supply an excessive amount of ink to the flexographic printing plate for the purpose of accelerating ink adhesion evaluation, the pressure of the anilox roll was increased by 0.02 mm from the proper value; and a relief surface was largely deformed, and the applied pressure was also increased by 0.15 mm from the proper value so as to accelerate ink adhesion.

After printing for 100 m, the anilox roll was detached from the flexographic printing plate.

Thereafter, printing was carried out for 10 m in no contact of the flexographic printing plate with the anilox roll to remove redundant ink from the flexographic printing plate surface.

Thereafter, the printer was stopped, and evaluation was conducted in a state of ink remaining in a halftone part of the flexographic printing plate. The halftone to be evaluated was a total of 10 locations of portions with halftone areas of 3 and 30% provided in each of AM 100, 133, 150, 175, and 200 lines placed in an image. After the completion of printing, a portion between halftone dots (concave portion) in the obtained flexographic printing plate was observed with a magnifier.

Evaluation criteria for the observation results are shown below.

In the following evaluation criteria, a sample given a score of 3 or higher was evaluated as being practically usable without any problem.

**EP 4 324 652 A1**

<Evaluation Criteria>

5: No adhesion is seen in the halftones of the 10 sites.
4: The number of halftone sites having ink adhesion over 10% or more of the image area among the halftones of the 10 sites is 1 to 2.
3: The number of halftone sites having ink adhesion over 30% or more of the image area among the halftones of the 10 sites is 1 to 2.
2: The number of halftone sites having ink adhesion over 30% or more of the image area among the halftones of the 10 sites is 3 to 5.
1: The number of halftone sites having ink adhesion over 30% or more of the image area among the halftones of the 10 sites is 6 or more.

[Table 3]

| | Photosensitive resin composition | | Development medium (nonwoven fabric) for heat development | | | Ink adhesion evaluation |
|---|---|---|---|---|---|---|
| | Type | Amount of component of Mw ≥ 70000 [%] | Type | Elastic recovery rate [%] | Resin material | |
| Example 101 | 1 | 74.3 | Example 5 | 86.5 | PET | 5 |
| Example 102 | 6 | 72.1 | Example 5 | 86.5 | PET | 5 |
| Example 103 | 2 | 62.4 | Example 5 | 86.5 | PET | 4 |
| Example 104 | 3 | 78.9 | Example 5 | 86.5 | PET | 4 |
| Example 105 | 4 | 83.6 | Example 5 | 86.5 | PET | 3 |
| Example 106 | 1 | 74.3 | Example 4 | 91.7 | PET | 5 |
| Example 107 | 1 | 74.3 | Example 6 | 83.1 | Ny | 4 |
| Example 108 | 1 | 74.3 | Example 1 | 69.2 | PET/ CoPET | 5 |
| Example 109 | 1 | 74.3 | Example 2 | 93.2 | PET | 5 |
| Example 110 | 1 | 74.3 | Example 3 | 96.8 | PET | 4 |
| Comparative Example 101 | 1 | 74.3 | Comparative Example 1 | 38.9 | Ny | 1 |
| Comparative Example 102 | 1 | 74.3 | Comparative Example 2 | 31.7 | PET | 2 |
| Comparative Example 103 | 5 | 58.1 | Comparative Example 2 | 31.7 | PET | 1 |

The present application is based on Japanese Patent Application No. 2021-068920 filed with the Japan Patent Office on April 15, 2021 and Japanese Patent Application No. 2021-068918 filed with the Japan Patent Office on April 15, 2021, the contents of which are incorporated herein by reference.

Industrial Applicability

The development medium for flexographic heat development and the heat development system of the present invention have industrial applicability in wide general commercial printing fields.

**Claims**

1. A development medium for flexographic heat development, the development medium having

   a porosity of 35% or more and 95% or less, and
   an elastic recovery rate of 40% or more and 99% or less.

2. The development medium according to claim 1, wherein the elastic recovery rate is 65% or more and 99% or less.

3. The development medium according to claim 1 or 2, wherein
   a grade of Gakushin abrasion fuzz is grade 4.0 or higher and grade 5.0 or lower.

4. The development medium according to any one of claims 1 to 3, wherein
   an opening size is 1.0 $\mu$m or larger and 50.0 $\mu$m or smaller.

5. The development medium according to any one of claims 1 to 4, wherein
   a fiber length is 50 mm or larger.

6. The development medium according to any one of claims 1 to 5, wherein
   the development medium comprises a polyester-based resin and/or a polyester-based copolymer.

7. The development medium according to any one of claims 1 to 6, wherein
   the development medium comprises a fiber layer having a fiber diameter of 0.1 $\mu$m or larger and 5.0 $\mu$m or smaller.

8. The development medium according to any one of claims 1 to 7, wherein

   the development medium comprises at least two fiber layers having a fiber diameter of 5.0 $\mu$m or larger and 30.0 $\mu$m or smaller, and
   the fiber layer having a fiber diameter of 0.1 $\mu$m or larger and 5.0 $\mu$m or smaller is included as an intermediate layer between the fiber layers having a fiber diameter of 5.0 $\mu$m or larger and 30.0 $\mu$m or smaller.

9. The development medium according to any one of claims 1 to 8, wherein
   a weight basis is 10 g/m$^2$ or more and 60 g/m$^2$ or less.

10. The development medium according to any one of claims 1 to 9, wherein
    a thickness is 15 $\mu$m or larger and 300 $\mu$m or smaller.

11. A heat development method using a heat development system of an original flexographic printing plate,

    the heat development system of an original flexographic printing plate having: a melting unit that melts a non-exposed portion of a photosensitive resin composition; and an absorption removal unit having an absorbent layer, wherein
    the absorbent layer is the development medium according to any one of claims 1 to 10, and
    the heat development method comprises absorbing and removing the non-exposed portion by contacting the absorbent layer with the non-exposed portion.

12. A heat development system of an original flexographic printing plate, comprising:

    a melting unit that melts a non-exposed portion of a photosensitive resin composition; and
    an absorption removal unit that absorbs and removes the non-exposed portion by contacting an absorbent layer with the non-exposed portion, wherein
    the absorbent layer is the development medium according to any one of claims 1 to 10.

13. The heat development system according to claim 12, wherein

    in the photosensitive resin composition,
    an amount of a component having a weight average molecular weight (Mw) of 70000 or more by GPC measurement is 60% or more.

14. The heat development system according to claim 12 or 13, wherein

in the photosensitive resin composition,
the amount of the component having the weight average molecular weight (Mw) of 70000 or more by GPC measurement is 60% or more and 80% or less.

## INTERNATIONAL SEARCH REPORT

| | International application No. |
|---|---|
| | **PCT/JP2022/016060** |

**A. CLASSIFICATION OF SUBJECT MATTER**

*B41C 1/00*(2006.01)i; *D04H 13/00*(2006.01)i; *G03F 7/00*(2006.01)i; *G03F 7/095*(2006.01)i; *G03F 7/36*(2006.01)i
FI: G03F7/00 502; D04H13/00; G03F7/095; B41C1/00; G03F7/36

According to International Patent Classification (IPC) or to both national classification and IPC

**B. FIELDS SEARCHED**

Minimum documentation searched (classification system followed by classification symbols)

G03F7/00; G03F7/095; G03F7/36

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2013/154180 A1 (TORAY INDUSTRIES, INC.) 17 October 2013 (2013-10-17) table 1, examples 1-23, comparative examples 1-4 | 1-10 |
| Y | | 11-14 |
| Y | JP 2003-131376 A (ASAHI KASEI CORP.) 09 May 2003 (2003-05-09) examples | 11-14 |
| A | JP 2009-109605 A (ASAHI KASEI CHEMICALS CORP.) 21 May 2009 (2009-05-21) examples | 1-14 |

☐ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **07 June 2022** | **21 June 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
**Information on patent family members**

International application No.

**PCT/JP2022/016060**

| Patent document cited in search report | | | Publication date (day/month/year) | Patent family member(s) | Publication date (day/month/year) |
|---|---|---|---|---|---|
| WO | 2013/154180 | A1 | 17 October 2013 | (Family: none) | |
| JP | 2003-131376 | A | 09 May 2003 | (Family: none) | |
| JP | 2009-109605 | A | 21 May 2009 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3117749 B
- JP 2009109606 A
- JP 5827746 B
- WO 2004104701 A
- JP 2021068920 A
- JP 2021068918 A